# EUROPÄISCHE PATENTSCHRIFT

(11) **EP 4 068 138 B1**
(45) Veröffentlichungstag und Bekanntmachung des Hinweises auf die Patenterteilung: **22.01.2025**
(21) Anmeldenummer: 22163008.0
(22) Anmeldetag: 18.03.2022
(51) Int. Cl.: G06F 30/20, G06F 9/50, G06F 30/331

(54) **VERFAHREN ZUR AUFTEILUNG VON SIMULATIONSMODELLEN ZWISCHEN EINEM PROZESSOR UND EINEM FPGA**
METHOD FOR SPLITTING SIMULATION MODELS BETWEEN A PROCESSOR AND AN FPGA
PROCÉDÉ DE RÉPARTITION DES MODÈLES DE SIMULATION ENTRE UN PROCESSEUR ET UN FPGA

(30) Priorität: 26.03.2021 DE 102021107636
(43) Veröffentlichungstag der Anmeldung: 05.10.2022
(73) Patentinhaber: dSPACE GmbH, 33102 Paderborn (DE)
(72) Erfinder: Lubeley, Dominik, 33102 Paderborn (DE); Agne, Andreas, 33102 Paderborn (DE)

(56) Entgegenhaltungen:
- EP-B1- 1 971 944
- US-B1- 7 509 244
- US-B2- 10 454 713

## Beschreibung

Die Erfindung betrifft ein Verfahren zur Aufteilung von Simulationsmodellen, die gemeinschaftlich auf einem Prozessor und einem programmierbaren Logikbaustein ausgeführt werden.

Solche Simulationsmodelle werden beispielsweise im Rahmen einer Hardware-inthe-Loop-Simulation verwendet, bei welcher Steuergeräte, insbesondere Steuergeräte für Kraftfahrzeuge, einer Prüfung auf korrekte Funktion unterzogen werden. Hierzu wird das zu prüfende Steuergerät an eine auch als I/O-Schaltung bezeichnete elektronische Schaltung mit Ein- und/oder Ausgabekanälen angeschlossen, um über die Schaltung Signale auf das Steuergerät aufzuprägen und/oder von diesem erzeugte Signale zu erfassen.

Die von der I/O-Schaltung auszugebenden Signale werden ermittelt, indem auf einer Simulationsumgebung das Softwaremodell einer Testumgebung läuft, bei einem Kraftfahrzeug z.B. die Simulation einer Fahrt. Simulierte Ereignisse werden durch elektrische, die Ereignisse repräsentierende Signale an die Ausgabekanäle, z.B. die Pins oder Register der Ausgabekanäle der Schaltung angelegt, um so an das Steuergerät übertragen zu werden und/oder von Steuergerät werden Signale an die Eingabekanäle, z.B. die Pins oder Register der Eingabekanäle der Schaltung angelegt, um so erfasst und in der Simulationsumgebung verarbeitet werden zu können. So kann ein Steuergerät in einer simulierten Umgebung betrieben werden, als wenn es tatsächlich in der echten Umgebung betrieben würde.

Die Simulationsumgebung oder kurz der Simulator wird z.B. gebildet durch ein Echtzeitrechnersystem mit wenigstens einem Prozessor, welcher das Softwaremodell abarbeitet. Beispielsweise kann das Modell durch eine echtzeitfähige Software bzw. eine Vielzahl zusammenwirkender Softwaretools bereitgestellt werden, die vorzugsweise ein grafisches Benutzerinterface aufweist und besonders bevorzugt mittels Softwareobjekten programmiert wird. Die Software kann MATLAB, Simulink oder auch RTI (Real-Time-Interface) der Anmelderin, welche z.B. ein Verbindungsglied zu Simulink bildet, umfassen.

Softwareobjekte werden in vorgenannten Fällen z.B. grafisch als Block programmiert, insbesondere hierarchisch. Eine Simulationsumgebung ist jedoch nicht auf die Verwendung dieser jeweils beispielhaft genannten Software beschränkt. Das Softwaremodell ist entweder direkt nach Programmierung oder nach Codegenerierung und Compilierung auf der Simulationsumgebung lauffähig.

Neben der Prozessorschaltung, die den wenigstens einen Prozessor umfasst, umfasst die Simulationsumgebung häufig mindestens eine mit der Prozessorschaltung in Verbindung stehende I/O-Schaltung, welche die genannten Ein-/Ausgabekanäle aufweist. Sie dienen dazu, um an den Pins der Ausgabekanäle elektrische Signale auszugeben und/oder an den Pins der Eingangskanäle dort anliegende elektrische Signale zu erfassen, z.B. durch eine Analog/Digital-Wandlung, um die erfassten Signale einer Weiterverarbeitung zuzuführen, sei es auf der genannten elektronischen Schaltung oder auf weiterer Elektronik, die mit der Schaltung verbunden ist. Es kann auch vorgesehen sein, dass wenigstens eine solche I/O-Schaltung, welche Ein- und/oder Ausgabekanäle umfasst, mit einer Schaltung umfassend einen programmierbaren Logikbaustein, insbesondere einem Field Programmable Gate Array (FPGA), in Verbindung steht, um Signale von dieser zu erhalten oder an diese bereitzustellen. Die FPGA-Schaltung ihrerseits kann mit der Prozessorschaltung verbunden sein, so dass das Simulationsmodell teilweise auf der FPGA-Schaltung und teilweise auf der Prozessorschaltung ausgeführt werden kann.

Ein Echtzeitrechnersystem unterscheidet sich insbesondere dadurch von handelsüblichen Computersystemen, dass eine vorgegebene Latenz nicht überschritten wird, beispielsweise zwischen dem Eingang eines geänderten Sensorsignals und der daraus resultierenden Reaktion, wie der Ausgabe eines geänderten Ansteuersignals. Je nach zu simulierendem System kann dabei eine maximale Latenz von beispielsweise 1 Millisekunde oder kürzer erforderlich sein. Insbesondere eine Simulation des Antriebs eines elektrischen Fahrzeugs (E-Drive) bzw. eine Simulation von Leistungselektronik stellt hohe Anforderungen an die Schnelligkeit des Regelkreises, insbesondere mit maximal zulässigen Latenzen im Bereich von Mikrosekunden, so dass Echtzeitsimulationen häufig nicht mehr von reinen Prozessormodellen und prozessorgesteuerten I/O Kanälen abgedeckt werden, sondern die zeitkritischen Modellteile auf einer frei programmierbaren FPGA-Schaltung ausgeführt werden. Vorzugsweise ist die FPGA-Schaltung dabei so ausgestaltet, dass verschiedene I/O-Schaltung modular mit ihr verbunden werden können.

Insbesondere für komplexe Echtzeitsimulationen in den Bereichen e-Mobility, ADAS, oder Leistungselektronik werden daher Echtzeitrechnersysteme mit heterogenen Recheneinheiten wie einem oder mehreren Prozessoren und einem oder mehreren programmierbaren Logikbausteinen eingesetzt. Bisher musste der Nutzer die Einteilung, welchen Modellanteil er in welcher Domäne (Prozessor, FPGA) ausführen möchte, von Hand festlegen und modellieren. Aus der EP 1971944 B1 ist bereits eine automatische Auslagerung von Submodellen in eine andere Domäne bekannt, wobei aber nur ein explorativer Trial & Error Ansatz verfolgt wird, bei dem iteriert wird, bis ein bestimmtes Performance-Kriterium erfüllt ist, wie ein vorgegebenes Zeitverhalten.

Eine manuelle Identifikation und Verschiebung der Modellgrenze zwischen Prozessor- und FPGA-Anteilen ist bisher in folgenden typischen Anwendungsfälle erforderlich, in denen Modellteile auf verschiedene Domänen (um)verteilt werden müssen:
- Aufteilung des Modells beim Entwurf,
- weiterentwickelte FPGA Modelle, die über die Ressourcen des verwendeten FPGA hinauswachsen,
- Migration eines Projektes auf eine andere FPGA Plattform mit mehr/weniger Ressourcen,
- Verteilen großer FPGA Anwendungen auf mehrere FPGAs.

Die US 7 509 244 B1 offenbart ein Verfahren zum Aufteilen eines grafischen Simulationsmodells, bei dem über eine verteilte Bearbeitung verschiedener Modellteile die für ein Kompilieren des Simulationsmodells benötigte Zeit verringert wird.

Vor diesem Hintergrund besteht die Aufgabe der Erfindung darin, ein Verfahren und eine Vorrichtung anzugeben, welche den Stand der Technik weiterbilden und vorzugsweise ein automatisches bzw. computerunterstütztes Aufteilen von Simulationsmodellen in Prozessor- und FPGA-Anteile ermöglicht.

Die Aufgabe wird durch ein Verfahren zur Aufteilung eines grafischen Simulationsmodells in ein erstes Teilmodell und ein zweites Teilmodell mit den

Merkmalen von Anspruch 1 und ein Rechnersystem mit den Merkmalen von Anspruch 14 gelöst. Vorteilhafte Ausgestaltungen der Erfindung sind Gegenstand von abhängigen Unteransprüchen.

Es wird also ein Verfahren zur Aufteilung eines grafischen Simulationsmodells in ein erstes Teilmodell und ein zweites Teilmodell bereitgestellt, wobei die Funktionalität des Simulationsmodells in Form von Blöcken modelliert ist, die zumindest teilweise durch Signale verbunden sind, wobei die Blöcke periodisch ausgeführt werden und jedem Block des Simulationsmodell eine Sampling-Zeit zugeordnet ist, wobei das erste Teilmodell dazu bestimmt ist, auf einer ersten Recheneinheit, insbesondere einem Prozessor, ausgeführt zu werden, und das zweite Teilmodell dazu bestimmt ist, auf einer zweiten Recheneinheit, einem programmierbaren Logikbaustein, ausgeführt zu werden. Das Verfahren umfasst die aufeinanderfolgenden Schritte:
a. Identifizieren mindestens eines ersten Blocks als zum ersten Teilmodell gehörig und mindestens eines zweiten Blocks als zum zweiten Teilmodell gehörig, wobei die Zugehörigkeit anhand der Sampling-Zeit und/oder einer Ressourcen-Zuordnung bestimmt wird,
b. Suchen von zyklischen Gruppen aus Blöcken, wobei eine zyklische Gruppe zwei oder mehr Blöcke umfasst, die über mindestens ein Signal verbunden sind, wobei ein erster Block der zyklischen Gruppe ein Signal an einen zweiten Block in der Gruppe ausgibt und ein Ausgangssignal des zweiten 20 Blocks zumindest mittelbar empfängt,
   wobei eine zyklische Gruppe, deren Blöcke alle dieselbe Sampling-Zeit aufweisen, als atomar angesehen wird,
c. Identifizieren nichtzyklischer Gruppen aus Blöcken,
d. Zuordnen der einzelnen Blöcke aus den Gruppen zu dem ersten Teilmodell oder dem zweiten Teilmodell, wobei alle Blöcke einer atomaren zyklischen Gruppe demselben Teilmodell zugeordnet werden,
e. Erzeugen von Code für die erste Recheneinheit, insbesondere von Programmcode, aus dem ersten Teilmodell, und
f. Erzeugen von Code für die zweite Recheneinheit, von einem Konfigurationsbitstrom, aus dem zweiten Teilmodell.

Eine zyklische Gruppe umfasst zwei oder mehr Blöcke, die über mindestens ein Signal verbunden sind, wobei ein erster Block der zyklischen Gruppe ein Signal an einen zweiten Block in der Gruppe ausgibt und ein Ausgangssignal des zweiten Blocks zumindest mittelbar empfängt. Umfasst die zyklische Gruppe drei oder mehr Blöcke, so kann das Ausgangssignal des zweiten Blocks zunächst Eingangssignal eines dritten Blocks sein, und das Ausgangssignal des dritten Blocks kann mit dem ersten Block verbunden sein; somit empfängt der erste Block das Ausgangssignal des zweiten Blocks nicht direkt, sondern es erfolgt noch eine zwischengeschaltete Operation im dritten Block. Bei größeren zyklischen Gruppen können entsprechend weitere Blöcke zwischengeschaltet sein.

Bei einer nichtzyklischen Gruppe aus Blöcken gibt es keine Rückkopplung zwischen den Blöcken, bei der ein Ausgangssignal eines im Signalverlauf nachgeordneten Blocks wieder mit dem ersten Block im Signalverlauf verbunden ist.

Die Sampling-Zeit kann den Blöcken explizit zugeordnet sein, oder sich aus einer Vererbung bzw. Propagation ergeben. Beispielsweise kann das Simulationsmodell hierarchisch gestaltet sein, wobei mehrere untergeordnete Blöcke die Funktionalität eines übergeordneten Blocks implementieren, und wobei eine Sampling-Zeit des übergeordneten Blocks für alle untergeordneten Blöcke übernommen wird. Bei einem Block der einen Zugriff auf eine Hardwareschnittstelle modelliert, wie ein I/O-Port, kann die Sampling-Zeit durch Eigenschaften der Hardware bestimmt sein. Bei mehreren durch eine Signallinie verbundenen Blöcken kann es auch vorgesehen sein, dass eine Sampling-Zeit eines der Blöcke für alle signalmäßig verbundenen Blöcke propagiert bzw. übernommen wird.

Die Erfindung bietet ein deterministisches, regelbasiertes Verfahren, das durch Transformation und Analyse eines Gesamtmodels die Grenze zwischen Prozessor und FPGA Anteil für alle Signalpfade an geeigneter Stelle vorschlägt und/oder Vorschläge für eine Verschiebung einer vorhandenen Grenze liefert. Dazu wird das Model in Partitionen unterteilt, die sich entweder für die Ausführung auf dem FPGA oder auf dem Prozessor oder FPGA eignen.

Vorzugsweise können die vorgeschlagenen Grenzen vom Modellierer in einer Modellansicht, welche die Partitionen beispielsweise durch eine Einfärbung anzeigt, jeweils Richtung FPGA oder Prozessor verschoben werden. Die Erfindung hat den Vorteil, dass sie sich für eine zyklusakkurate, also taktgenaue Modellierung eignet, mit der sich anspruchsvolle Regelkreise z.B. im Bereich E-Drive realisieren lassen.

Das erfindungsgemäße Verfahren ist prinzipiell für verschiedene Arten von Recheneinheiten wie CPUs, GPUs und FPGAs anwendbar. Weiterhin kann es prinzipiell auch für eine größere Anzahl von Teilmodellen eingesetzt werden.

Für hierarchisch gestaltete Simulationsmodelle, bei denen das Simulationsmodell mindestens einen Block in einer ersten Hierarchieebene und mindestens einen Block in einer zweiten Hierarchieebene umfasst, erfolgt bevorzugt vor den weiteren Schritten ein Zusammenführen der Blöcke des Simulationsmodells in einer gemeinsamen Hierarchieebene. Dies vereinfacht und beschleunigt die Aufteilung des Modells.

Wenn das Simulationsmodell Eingangsports, Ausgangsports und/oder Busse enthält, umfasst der Schritt des Zusammenführens der Blöcke des Simulationsmodells in einer gemeinsamen Hierarchieebene vorzugsweise ein Entfernen zumindest von einigen der Eingangsports, Ausgangsports und/oder Busse sowie ein Einfügen entsprechender Signale. Mit Eingangsports und Ausgangsports sind hierbei in erster Linie Intra-Modell-Kommunikationsblöcke gemeint, die unterschiedliche Bereiche bzw. Hierarchieebenen des Modells verbinden. Auch ein Paar aus Goto- und From-Block, welches eine Datenverbindung zwischen zwei Blöcken bzw. Modellteilen angibt, kann zweckmäßigerweise als ein Paar aus Eingangs- und Ausgangsport behandelt und entfernt bzw. durch eine Signalline ersetzt werden. I/O-Ports, die fest einer Hardwareressource wie einem I/O-Pin eines FPGA oder einen Wandlerbaustein eines I/O-Boards zugeordnet sind, verbleiben im Modell.

Vorzugsweise wird ein Block als zum zweiten Teilmodell gehörend identifiziert, wenn eine oder mehrere der folgenden Bedingungen erfüllt ist/sind:
I. dem Block ist eine Sampling-Zeit zugeordnet, die unterhalb eines vorgegebenen Samplingschwellenwerts liegt;
II. dem Block ist eine Latenz zugeordnet, die unterhalb eines vorgegebenen Latenzschwellenwerts liegt;
III. dem Block ist eine Ressource des programmierbaren Logikbausteins zugeordnet, wie insbesondere ein I/O-Pin des programmierbaren Logikbausteins.

Blöcke mit besonders hohen Anforderungen an das Zeitverhalten, wie ein häufiges Sampling und/oder eine kurze Latenz, werden zweckmäßigerweise dem zweiten Teilmodell zugeordnet, welches auf dem programmierbaren Logikbaustein bzw. FPGA ausgeführt wird. Bei Blöcken mit direktem Hardwarezugriff folgt die Modellzuordnung direkt der entsprechenden Hardware-Einheit.

Bevorzugt wird ein Block als zum ersten Teilmodell gehörend identifiziert, wenn eine oder mehrere der folgenden Bedingungen erfüllt ist/sind:
I. der Block beschreibt einen Funktionsaufruf, insbesondere eine Funktion des Betriebssystems und/oder einen Zugriff auf eine Netzwerkschnittstelle;
II. dem Block ist eine Ressource des Prozessors zugeordnet, wie insbesondere ein Register des Prozessors.

Blöcke, die eine Softwareschnittstelle modellieren oder eine Hardwareressource des Prozessors ansprechen, werden zweckmäßigerweise dem ersten Teilmodell zugeordnet.

Es ist vorteilhaft, wenn der Schritt des Suchens von zyklischen Gruppen eine rekursive Unterteilung umfasst, wobei für eine gefundene zyklische Gruppe überprüft wird, ob alle Blöcke die gleiche Sampling-Zeit haben, wobei in dem Fall die zyklische Gruppe als atomar angesehen und beibehalten wird, und andernfalls die zyklische Gruppe zwischen Blöcken mit unterschiedlicher Sampling-Zeit in neue zyklische oder nichtzyklische Teilgruppen unterteilt wird, bis keine unterteilbaren zyklischen Gruppen mehr vorliegen. Auch ein Zähler kann vorzugsweise als eine zyklische Gruppe aus Addierer und Register behandelt werden. Eine atomare zyklische Gruppe wird zweckmäßigerweise nur als Ganzes dem ersten oder dem zweiten Teilmodell zugeordnet.

Gemäß einer bevorzugten Ausführungsform der Erfindung erfolgt der Schritt des Zuordnens der einzelnen Blöcke aus den Gruppen zu dem ersten Teilmodell oder dem zweiten Teilmodell anhand einer vorgegebenen Regel. Es kann auch ein Regelsatz aus mehreren verschachtelten Bedingungen vorgegeben werden. Durch das Abarbeiten von Regeln, die eine oder mehrere Bedingungen überprüfen, kann die Zuordnung der Blöcke schnell und reproduzierbar erfolgen.

Besonders bevorzugt werden gemäß der Regel alle Blöcke, die nicht auf dem programmierbaren Logikbaustein ausgeführt werden müssen, dem ersten Teilmodell zugeordnet. Dadurch werden nur die besonders zeitkritischen Blöcke auf dem FPGA ausgeführt, und die häufig knappen Ressourcen des programmierbaren Logikbausteins werden geschont.

Insbesondere kann es vorgesehen sein, dass ein Block auch dann auf dem programmierbaren Logikbaustein ausgeführt werden muss bzw. wird, wenn dieser über ein Signal mit einem als zum zweiten Teilmodell gehörend identifizierten Block verbunden ist, und das Signal eine höhere Bitbreite als ein Breitenschwellenwert und/oder eine höhere Änderungsfrequenz als ein Änderungsschwellenwert und/oder das Signal eine kürzere Latenz als ein Signallatenzschwellenwert aufweist. Es kann auch die Bandbreite als Produkt aus Signalbreite und Änderungsfrequenz betrachtet werden, wobei ein Block auf dem FPGA ausgeführt wird, wenn die Bandbreite einen vorgegebenen Bandbreitenschwellenwert überschreitet. Es kann vorgesehen sein, dass mehrere Signale als ein Signal mit kumulativer bzw. addierter Bitbreite angesehen werden. Wenn zwischen zwei Blöcken viele Daten übertragen werden müssen, werden diese zweckmäßigerweise auf derselben Recheneinheit angeordnet, insbesondere dem programmierbaren Logikbaustein. Wenn die Signalübertragung zwischen zwei Blöcken nur mit geringer Latenz erfolgen darf, ist es vorteilhaft, diese Blöcke auf dem programmierbaren Logikbaustein auszuführen bzw. zu implementieren.

Bevorzugt wird nach dem Schritt des Zuordnens der einzelnen Blöcke aus den Gruppen zu dem ersten Teilmodell oder dem zweiten Teilmodell eine grafische Darstellung des aufgeteilten Modells über eine Benutzeroberfläche angezeigt. Änderungen an der Aufteilung werden zweckmäßigerweise über die Benutzeroberfläche empfangen.

Besonders bevorzugt werden anhand einer Zusatzregel Blöcke identifiziert, die sowohl dem ersten Teilmodell als auch dem zweiten Teilmodell zugeordnet werden können, wobei diese Blöcke hervorgehoben auf der Benutzeroberfläche dargestellt werden. Die Zuordnung dieser Blöcke erfolgt anhand einer Benutzereingabe. Insbesondere kann gemäß der Zusatzregel anhand des Fehlens einer Ressourcen-Zuordnung ein Block identifiziert werden, welcher beliebig zugeordnet werden kann. Beispielsweise kann ein Nutzer über einen Slider einen Anteil des Modells vorgeben, der auf dem programmierbaren Logikbaustein ausgeführt wird; alternativ oder ergänzend kann es auch vorgesehen sein, dass gewünschte Grenzen in die grafische Darstellung des Modells eingefügt werden können. Insbesondere können gewünschte Grenzen über eine Mausbewegung empfangen werden. Die vom Nutzer festgelegten Grenzen werden zweckmäßigerweise in den Modelleigenschaften oder einem dafür vorgesehenen Block im Modell gespeichert, insbesondere indem eine geänderte Zuordnung als Blockparameter hinterlegt wird. Alternativ kann es vorgesehen sein, die vom Nutzer festgelegten Grenzen in einer separaten Datei oder einer Datenbank abzulegen. Dies ermöglicht das parallele Bestehen mehrerer verschiedener Partitionierungen, wobei insbesondere eine aktive Partitionierung voreingestellt sein kann.

Vorzugsweise erfolgt nach dem Schritt des Zuordnens der einzelnen Blöcke aus den Gruppen zu dem ersten Teilmodell oder dem zweiten Teilmodell ein zusätzlicher Schritt des Einfügens von Kommunikationsblöcken, wobei für zwei durch ein Signal verbundene Blöcke überprüft wird, ob diese unterschiedlichen Teilmodellen zugeordnet sind, und in dem Fall ein Paar von Kommunikationsblöcken eingefügt wird, die einen Datenaustausch zwischen Prozessor und programmierbarem Logikbaustein implementieren.

In einer bevorzugten Ausführungsform der Erfindung umfasst das Verfahren die weiteren Schritte
g. Übertragen des Programmcodes und des Konfigurationsbitstroms auf ein Echtzeitrechnersystem umfassend einen Prozessor und einen programmierbaren Logikbaustein, und
h. Durchführen einer Simulation, wobei der Prozessor den Programmcode ausführt und die Funktionalität des programmierbaren Logikbausteins durch den Konfigurationsbitstrom bestimmt wird.

Die aus einem erfindungsgemäß aufgeteilten Simulationsmodell generierte Anwendung umfassend Programmcode für einen Prozessor und Konfiguration für einen programmierbaren Logikbaustein, kann direkt ausgeführt werden. Ein mit dem entsprechenden Programmcode bzw. Konfigurationsbitstrom betriebener Echtzeitrechner kann eine Simulation durchführen bzw. allgemein eine beliebige in dem Simulationsmodell spezifizierte Funktionalität bereitstellen.

Die Erfindung betrifft weiterhin ein Rechnersystem, umfassend einen Bedienrechner mit einer Bedienoberfläche und einem Echtzeitrechner mit einem Prozessor, einem programmierbaren Logikbaustein und I/O-Schaltungen. Auf einem nichtflüchtigen Speicher des Rechnersystems sind Instruktionen zur Durchführung eines erfindungsgemäßen Verfahrens hinterlegt.

Ferner betrifft die Erfindung einen nichtflüchtigen Datenträger mit einem computerlesbaren Speichermedium, auf dem Befehle eingebettet sind, die, wenn sie von einem Prozessor ausgeführt werden, bewirken, dass der Prozessor dazu eingerichtet ist, ein erfindungsgemäßes Verfahren auszuführen. Häufig weist ein Bedienrechner eines Echtzeitrechnersystems eine Modellierumgebung auf und ist somit besonders gut zur Durchführung einer erfindungsgemäßen Aufteilung des Modells geeignet. Weiterhin kann automatisiert Programmcode bzw. eine FPGA-Konfiguration erstellt und auf dem Echtzeitrechnersystem ausgeführt werden, wodurch sich ein hoher Bedienkomfort ergibt.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Abmessungen sind nicht maßstäblich und weisen, sofern nicht anders angegeben, auch keine ableitbaren geometrischen Relationen zueinander auf.

Darin zeigt:
- Figur 1: eine schematische Ansicht einer beispielgemäßen Hardware-in-the-Loop-Testumgebung,
- Figur 2: eine schematische Ansicht eines Simulators, der ein erstes Teilmodell auf einem Prozessor und ein zweites Teilmodell auf einem FPGA ausführt,
- Figur 3: ein hierarchisches Simulationsmodell,
- Figur 4: ein auf eine Ebene zusammengeführtes Simulationsmodell,
- Figur 5: einen schematischen Ablaufplan eines erfindungsgemäßen Verfahrens,
- Figur 6: eine schematische Darstellung eines Modells mit zwei Fixpunkten und einer atomaren zyklischen Gruppe,
- Figur 7: eine schematische Darstellung einer unterteilbaren zyklischen Gruppe, die eine atomare zyklische Gruppe mit schneller Samplingrate und eine nichtzyklische Gruppe mit langsamer Samplingrate umfasst,
- Figur 8: eine schematische Darstellung eines Modells mit mehreren zyklischen und nichtzyklischen Gruppen,
- Figur 9: eine schematische Darstellung zum Fine-Tuning, bzw. dem Festlegen der Grenze innerhalb der nicht-zyklischen Modellanteile, wobei exemplarisch mehrere mögliche Grenzen angedeutet sind,
- Figur 10a: eine schematische Darstellung eines einfachen Modells mit einer Grenze,
- Figur 10b: eine schematische Darstellung des einfachen Modells, bei dem durch das Verschieben der Grenze weitere Grenzen im Signalpfad eingefügt wurden, und
- Figur 10c: eine schematische Darstellung des einfachen Modells, bei dem die verschobene Grenze beibehalten wurde, aber die Anzahl von weiteren Grenzen verringert wurde.

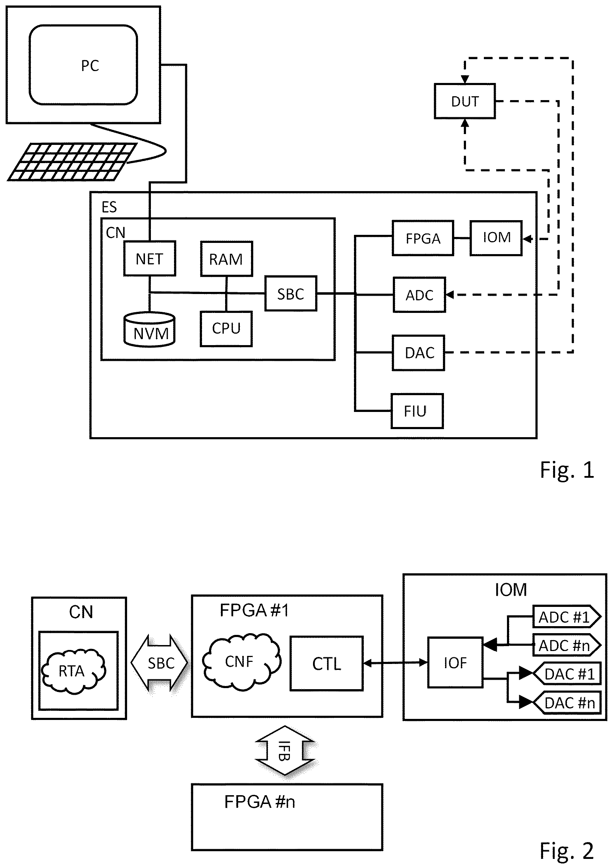

In Figur 1 ist schematisch eine beispielgemäße Hardware-in-the-Loop-Testumgebung mit einem Bedienrechner PC, einem Simulator ES und einem zu testenden Steuergerät DUT dargestellt. Der Bedienrechner PC kann als ein handelsüblicher Personal Computer mit Bildschirm, Eingabegeräten und einer oder mehreren Netzwerkschnittstellen ausgestaltet sein.

Der echtzeitfähige Simulator ES umfasst einen Rechenknoten CN, der über eine Netzwerkschnittstelle NET mit dem Bedienrechner PC verbunden ist. Der Rechenknoten CN weist mindestens einen Prozessor CPU, insbesondere einen Mehrkernprozessor, einen Arbeitsspeicher RAM und einen nichtflüchtigen Speicher NVM auf, auf dem vorzugsweise ein Betriebssystem und/oder ein Bootloader hinterlegt sind. Über einen Hochgeschwindigkeitsbus SBC bzw. einen entsprechenden Controller sind ein Logikboard mit einem programmierbaren Logikbaustein FPGA, zwei I/O-Schaltungen ADC, DAC und eine Fehlersimulationsschaltung FIU mit dem Rechenknoten verbunden. Der programmierbare Logikbaustein FPGA ist bevorzugt frei programmierbar und kann gemäß der vorliegenden Erfindung konfiguriert werden. Es kann auch vorgesehen sein, dass der Simulator ES mehrere Logikboards bzw. mehrere programmierbare Logikbausteine FPGA auf einem Logikboard aufweist. Das Logikboard weist vorzugsweise einen oder mehrere Steckplätze für I/O-Module auf. Dargestellt ist ein I/O-Modul IOM, welches mit dem zu testenden Steuergerät DUT verbunden ist und beispielsweise digitale Eingangs- und Ausgangssignale mit diesem austauschen kann. Die I/O-Schaltung ADC weist einen oder mehrere Analog-Digitalwandler auf, der oder die analoge Signale des zu testenden Steuergerät DUT empfängt bzw. empfangen. Über die I/O-Schaltung DAC, welche einen oder mehrere Digital-Analog-Wandler aufweist, kann der Simulator ES analoge Signale an das zu testende Steuergerät DUT ausgeben. Die Fehlersimulationsschaltung FIU kann angeschlossene Geräte mit definierten elektrischen Fehlern beaufschlagen, wie beispielsweise einen Kurzschluss zweier Kanäle.

Frei programmierbare Logikbausteine FPGA werden insbesondere für Anwendungsbereiche wie E-Drive und Leistungselektronik eingesetzt, weil dort besonders schnelle Regelkreise auftreten. Zweckmäßigerweise weisen Logikboards mit einem solchen FPGA mehrere Steckplätze für I/O-Module auf; beispielsweise bietet dSPACE das DS6601 FPGA Base Board mit fünf Steckplätzen an, die mit unterschiedlichen I/O-Module bestückt werden können. Eine bestehende Testumgebung kann durch den Einbau eines neuen I/O-Moduls beispielsweise um eine Analog-Digital-Wandlung mit einer hohen Auflösung erweitert werden.

Figur 2 zeigt eine schematische Ansicht eines Simulators, der ein erstes Teilmodell auf einem Prozessor und ein zweites Teilmodell auf einem FPGA ausführt. Auf dem Rechenknoten CN ist ein erstes Teilmodell RTA hinterlegt, welches als Echtzeitapplikation vom Prozessor des Rechenknotens ausgeführt wird. Der programmierbare Logikbaustein FPGA#1 ist so konfiguriert, dass auf einem Teil der Fläche ein zweites Teilmodell CNF und auf einem anderen Teil der Fläche ein Steuerungsmodul CTL implementiert ist. Das Steuerungsmodul CTL ist über Baustein IOF mit einem I/O-Modul IOM verbunden, welches Analog-Digital-Wandler ADC#1, ADC#n und Digital-Analog-Wandler DAC#1 und DAC #n aufweist. Rechenknoten und programmierbarer Logikbaustein sind über den Hochgeschwindigkeitsbus SBC verbunden. Über einen Inter-FPGA-Bus ist der programmierbare Logikbaustein FPGA#1 mit einem zweiten programmierbaren Logikbaustein FPGA#n verbunden.

Das erfindungsgemäße Verfahren kann optional auch für die Aufteilung in mehrere Teilmodelle verwendet werden, wie ein drittes Teilmodell, das auf dem zweiten programmierbaren Logikbaustein FPGA#n implementiert ist. Neben Prozessoren und programmierbaren Logikbausteinen können weitere Komponenten eines heterogenen Rechensystems unterstützt werden, wie z.B. GPUs oder KI-Cores; hierbei wären die Schritte analog, wobei lediglich die Zuordnung der einzelnen Blöcke auf die Teilmodelle anhand eines jeweiligen Regelwerks erfolgt, das an die verschiedenen Architekturen angepasst ist.

Prinzipiell lässt sich das erfindungsgemäße Verfahren mit entsprechend angepasstem Regelwerk also auf die Grenze zwischen beliebigen Domänen wie Programmierbarer Logikbaustein - programmierbarer Logikbaustein, Programmierbarer Logikbaustein - Grafikkarte bzw. GPU, Prozessor und Prozessor / Mikrocontroller, Prozessor und Grafikkarte bzw. GPU, erste Grafikkarte und zweite Grafikkarte, oder auch mehr als 2 Domänen pro Model erweitern.

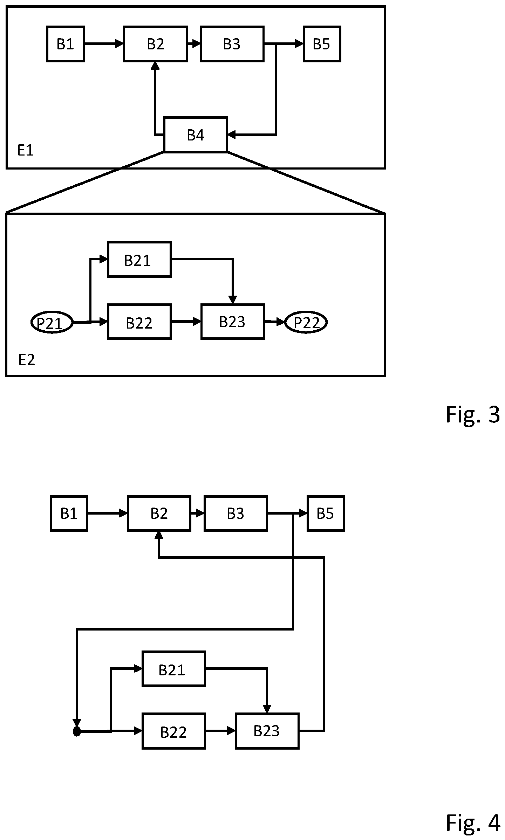

In Figur 3 ist schematisch ein hierarchisches Simulationsmodell dargestellt. In einer ersten Hierarchieebene E1 sind mehrere Blöcke B1, B2, B3, B4 und B5 angeordnet, welche die Funktionalität des Modells implementieren und durch Signale verbunden sind. Block B4 ist ein Subsystem, dessen Funktionalität durch untergeordnete Blöcke in einer zweiten Hierarchieebene implementiert ist. Die zweite Hierarchieebene E2 umfasst Eingangsport P11, Blöcke B21, B22, B23 und Ausgangsport P22.

Figur 4 zeigt das Simulationsmodell nach dem Zusammenführen der Blöcke in einer gemeinsamen Hierarchieebene. Die Blöcke B1, B2, B3 und B5 sind weiterhin vorhanden. Subsystem B4 wurde durch die untergeordneten Blöcke B21, B22 und B23 ersetzt. Eingangsport P11 und Ausgangsport P22, welche der Intra-Modell-Kommunikation dienten und nicht mit einer Hardwareressource verbunden waren, wurden entfernt und durch direkte Signalverbindungen zu den Blöcken B2 und B3 ersetzt.

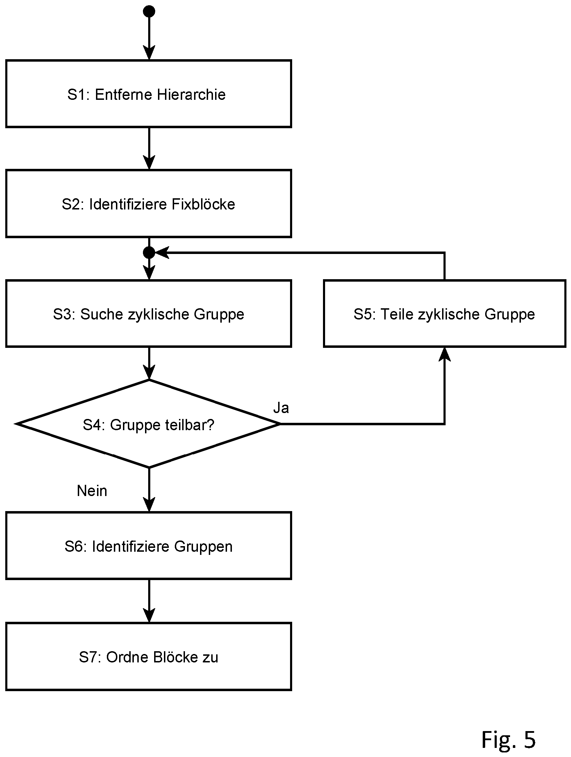

In Figur 5 ist ein schematischer Ablaufplan eines Verfahrens gemäß einer bevorzugten Ausführungsform der Erfindung dargestellt.

Ausgangspunkt eines erfindungsgemäßen Verfahrens ist zweckmäßigerweise ein Gesamtmodell mit Sampling-Zeiten, also ein Gesamtmodell, in dem jedem Block entweder explizit oder implizit (z.B. über Default-Einstellungen oder durch Vererbung) eine Sampling-Zeit zugeordnet ist. Unter einer Sampling-Zeit ist insbesondere die Zeit zu verstehen, nach welcher der Block erneut ausgeführt wird bzw. nach welcher der Block erneut seine Eingangssignale einliest und/oder ein neuer Ausgabewert des Blocks verfügbar ist. Außerdem wird zweckmäßigerweise davon ausgegangen, dass Blöcke atomar sind, die resultierende Partitionierung also nicht durch Blöcke hindurch verlaufen kann, sondern immer nur zwischen den Blöcken. Das Verfahren verläuft bevorzugt in folgenden Schritten:

In Schritt S1 (Entferne Hierarchie) werden - wie in Figur 3 und 4 gezeigt - die Blöcke eines hierarchischen Modells auf eine gemeinsame Hierarchieebene zusammengeführt. Die Analyse eines hierarchisch strukturierten Simulink Models mit Datenbussen wäre komplex und zeitaufwändig; zweckmäßigerweise werden daher in dem vorbereitenden Schritt strukturgebende Elemente wie Subsysteme und Busse entfernt bzw. durch einzelne Signale ersetzt. Das ermöglicht eine performante graphenbasierte Analyse, in der alle In/Out Ports eines Knoten und deren Ursprung direkt bekannt und durch eine Kante mit deren Ursprung und Ziel verbunden sind. Dieser Schritt ist optional und kann nach an sich bekannten Verfahren durchgeführt werden. Beispielsweise bietet die Entwicklungsumgebung Vivado von Xilinx ein solches Verfahren bei der Netzlistenoptimierung unter "flatten_hierarchy" an.

In Schritt S2 (Identifiziere Fixblöcke) wird mindestens ein erster Block als zum ersten Teilmodell gehörend und mindestens ein zweiter Block als zum zweiten Teilmodell gehörend identifiziert. Aus der Architektur resultierende Nebenbedingungen führen dazu, dass manche Blöcke zwingend auf FPGA, und manche zwingend auf dem Prozessor implementiert werden müssen. Die Zuordnung (Prozessor oder FPGA) dieser Blöcke steht damit bereits von vornherein fest, weshalb in einem ersten Schritt diese Fixpunkte identifiziert werden. Beispielsweise müssen Blöcke mit niedriger Latenz auf dem FPGA implementiert werden, während Blöcke hinter denen z.B. komplexe Interaktionen mit dem Betriebssystem stehen (z.B. Netzwerkprotokolle) auf dem Prozessor ausgeführt werden müssen. Darüber hinaus werden Blöcke, deren Sampling-Zeit unterhalb eines gegebenen Schwellwertes liegt, dem FPGA zugewiesen. Spezielle I/O Blöcke sind in der Regel eindeutig einer Domäne zugeordnet.

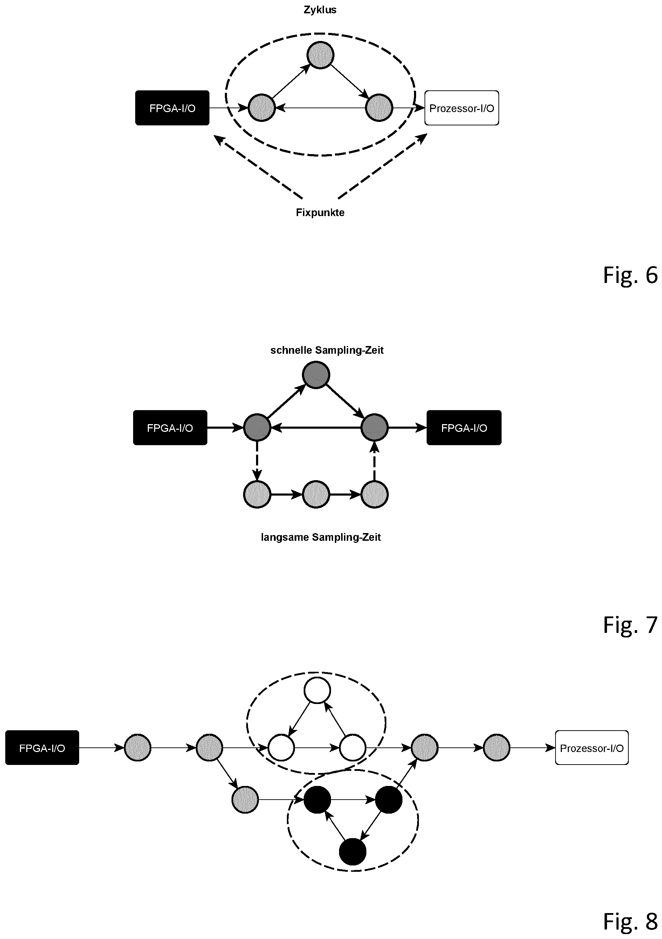

In Schritt S3 (Suche zyklische Gruppe) werden Gruppen aus Blöcken gesucht, deren Ausgabewerte zyklisch voneinander abhängen. Weist das Modell solche zyklischen Gruppen bzw. Zyklen auf, so werden diese Zyklen in einer von zwei Klassen zugeordnet. Solche Zyklen, in denen alle Knoten die gleiche Sample-Zeit haben, werden als atomar angesehen, und nicht weiter partitioniert. D.h. sie werden vollständig auf dem FPGA oder vollständig auf dem Prozessor implementiert und können nur als Ganzes über eine HW/SW-Grenze bewegt werden. I/O-Blöcke werden dabei zweckmäßigerweise nicht als Teil eines Zyklus angesehen. Figur 6 zeigt eine schematische Darstellung eines Modells mit zwei Fixpunkten und einer atomaren zyklischen Gruppe, bei der alle Blöcke die gleiche Samplingzeit besitzen.

In Schritt S4 (Gruppe teilbar?) wird überprüft, ob die zyklische Gruppe weiter unterteilt werden kann. Besitzen die Knoten des Zyklus unterschiedliche Sampling-Zeiten, so werden diese als nicht-atomar angesehen und können weiter unterteilt werden. Dies findet in Schritt S5 (Teile zyklische Gruppe) statt. Die Unterteilung erfolgt dabei an den Übergängen zwischen Anteilen unterschiedlicher Sampling-Zeit. Dadurch entstehen neue nichtzyklische und zyklische Teilbereiche, die dann gemäß dem vorliegenden Verfahren rekursiv weiter behandelt werden. Diese Rekursion wird vorliegend durch eine erneute Ausführung von Schritt S3 angedeutet. Figur 7 zeigt eine schematische Darstellung einer unterteilbaren zyklischen Gruppe, die einen Teil mit schneller Sampling-Zeit bzw. hoher Samplingrate und einen Teil mit langsamer Sampling-Zeit bzw. niedriger Samplingrate hat und somit in zwei Teile geteilt werden kann, eine atomare zyklische Gruppe und eine nichtzyklische Gruppe.

In Schritt S6 (Identifiziere Gruppen) werden nichtzyklische Gruppen aus Blöcken identifiziert. In diesem Schritt werden alle nicht-zyklischen (feed forward) Anteile des Modells identifiziert. Diese liegen grundsätzlich vor (Fan-In) oder nach (Fan-Out) den Fixpunkten und den Zyklen. In diesen Modellanteilen liegen die möglichen Partitionsgrenzen zwischen FPGA und Prozessor, d.h. zwischen den Blöcken einer nichtzyklischen Gruppe kann die Grenze zwischen erstem und zweitem Teilmodell frei gewählt werden.

In Schritt S7 (Ordne Blöcke zu) werden die einzelnen Blöcke in nichtzyklischen Gruppen bzw. alle Blöcke einer zyklischen Gruppe dem ersten Teilmodell oder dem zweiten Teilmodell zugeordnet. Nach der Identifikation der Fixpunkte, Zyklen, und der nichtzyklischen Abhängigkeiten, kann die Aufteilung des Gesamtmodells gemäß eines vorgegebenen Regelwerks erfolgen.

Die Regeln zur Entscheidung, wo ein gegebener Modellteil implementiert werden soll, können unter Berücksichtigung von Performance des Gesamtmodells, verfügbaren Ressourcen, Kommunikationskosten und Sampling-Zeiten getroffen werden. Es kann vorgesehen sein, dass die zugrunde liegenden Parameter anhand einer Benutzereingabe gewählt werden; aber auch eine Vorgabe anhand einer Heuristik oder ein Ausmessen sinnvoller Parameter durch eine Entwurfsraum-Exploration kann vorgesehen sein.

Zweckmäßigerweise wird zunächst für jeden atomaren Zyklus entschieden, wo dieser implementiert werden soll. Figur 8 zeigt eine schematische Darstellung der Zuordnung der zyklischen Gruppen eines beispielgemäßen Simulationsmodells zu dem ersten Teilmodell oder dem zweiten Teilmodell; die obere zyklische Gruppe (weiß gefüllte Kreise) wird dem ersten Teilmodell zugeordnet und auf dem Prozessor ausgeführt, die untere zyklische Gruppe (schwarz gefüllte Kreise) wird dem zweiten Teilmodell zugeordnet und auf dem FPGA ausgeführt.

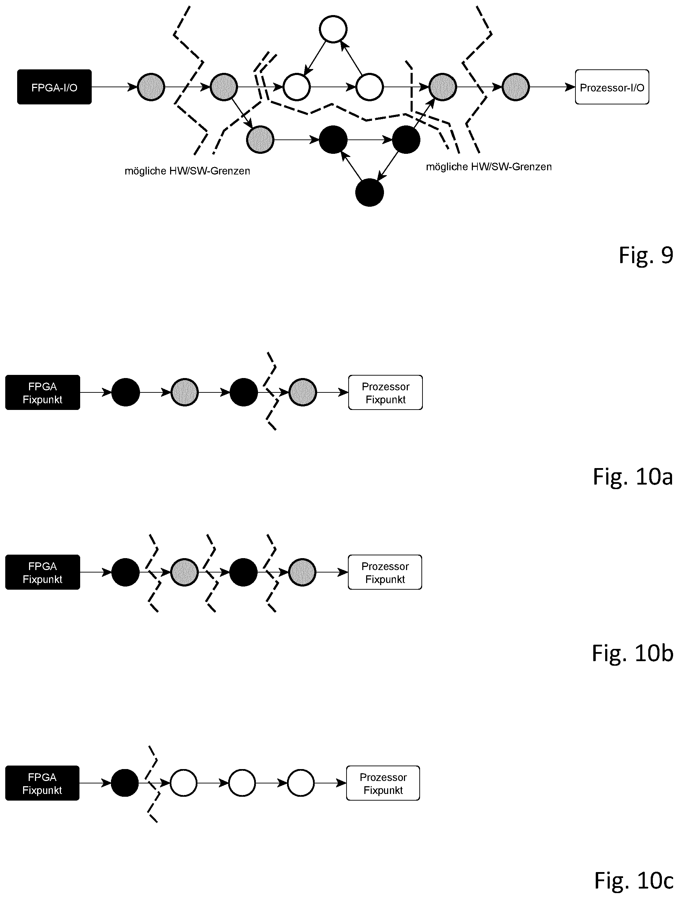

Nach der Zuordnung der Zyklen erfolgt bevorzugt das Fine-Tuning der Hardware-Software-Grenze zwischen den Blöcken in nichtzyklischen Gruppen, wobei diese Grenze nun innerhalb der nichtzyklischen Anteile Richtung FPGA oder Prozessor verschoben werden kann. Für die Zuordnung der Blöcke in nichtzyklischen Gruppen können die gleichen Kriterien wie für die Zuordnung der Zyklen angewandt werden. Der wesentliche Unterschied ist, dass die Grenze hier Block für Block verschoben werden kann, was einer feineren Granularität entspricht. Optional können Zyklen einer langsameren Domäne auch auf schnellere verschoben werden (z.B. Prozessor zu FPGA), wenn ihre Zuordnung nur durch die Sampling-Zeit bedingt war. Figur 9 zeigt eine schematische Darstellung zum Fine-Tuning bzw. dem Festlegen der Grenze innerhalb der nicht-zyklischen Modellanteile, wobei exemplarisch 5 mögliche Grenzen angedeutet sind.

Ein erfindungsgemäßes Verfahren kann eingesetzt werden, um ein noch nicht unterteiltes Gesamtmodell in Prozessor- und FPGA-Anteile zu partitionieren, oder um eine bestehende Unterteilung eines bereits in Prozessor und FPGA Anteile unterteilten Gesamtmodells neu vorzunehmen. Dabei werden bevorzugt folgende Schritte ausgeführt:
1. Partitionierung
2. Automatischer Vorschlag von Grenzen zwischen Prozessor und FPGA
3. Interaktive Verschiebung der Grenze

Vorzugsweise wird das erfindungsgemäße Verfahren zusammen mit einem Transformationstool wie dem HDL Coder von MathWorks oder dem Xilinx System Generator eingesetzt. Dann können Modellblöcke oder ganze Subsysteme auf einfache Weise sowohl im Prozessor- als auch FPGA-Modell genutzt werden, indem mittels dieser Tools für einen Block jeweils Quellcode für einen Prozessor oder HDL-Code für einen FPGA generiert wird.

Ein automatischer Vorschlag von Grenzen zwischen Prozessor und FPGA bietet sich an zur Partitionierung eines Gesamtmodells, das noch keine feste Zuordnung der Blöcke aufweist und nur aus Prozessor oder FPGA Anteilen besteht oder zur erneuten Partitionierung eines Gesamtmodels mit bereits festgelegten Partitionen für Prozessor und FPGA. Indem eine eventuell vorhandene Blockzugehörigkeit zu einer Domäne ignoriert wird, können beide Fälle gleichbehandelt werden.

Die Einteilung der Modelanteile in die Domänen erfolgt gemäß einer bevorzugten Ausführungsform der Erfindung anhand von folgenden zwei Regeln:
Regel 1: Modelanteile, die nicht auf dem FPGA laufen müssen, werden auf den Prozessor ausgelagert. Dabei ist Regel 2 zu berücksichtigen.
Regel 2: Da der Datentransfer bei ausgelagerten Rechnungen auf einem ggf. schnellerem Rechengerät den Zeitgewinn oft aufhebt, ist der Datentransfer zu minimieren. Daher wird als Grenze der unter Berücksichtigung von Regel 1 minimal mögliche Schnitt bezüglich Datenbreite im Modelgraph gezogen. Dadurch wird die Datentransferdauer minimiert.

Zusätzlich oder alternativ können Kriterien wie eine Task Turnaround Zeit eines Prozessormodells, eine Anzahl von maximal verfügbaren Logikressourcen wie FlipFlops, LUTs, DSPs, RAM, AI Cores eines FPGA-Modells oder ein vorgegebener Takt des programmierbaren Logikbausteins berücksichtigt werden. Diese Werte können auf Basis einer Synthese des Gesamtmodells ermittelt werden, auch wenn das Model als gesamtes viel zu groß für den FPGA wäre. In dieser Synthese wird zweckmäßigerweise eine "virtuelle" Netzliste erzeugt, aus der die Ressourcen der einzelnen Modelblöcke/Subsysteme und der ungefähr erreichbare Takt ermittelt und als Grundlage für ein Festlegen der Modelgrenzen verwendet werden. Auf die in einem regulären Build für einen programmierbaren Logikbaustein folgenden Schritte des Placements und Routings auf einen konkreten FPGA wird vorzugsweise verzichtet.

Nach der automatischen Unterteilung eines Modells kann vorzugsweise eine interaktive Verschiebung der Grenze zwischen Prozessor und FPGA erfolgen.

Ausgehend von einem in Partitionen für den FPGA und Partitionen für den Prozessor unterteilten Modell werden die unterschiedlichen Partitionen bevorzugt grafisch im Model hervorgehoben bzw. in einer grafischen Bedienoberfläche dargestellt. Zusätzlich werden vorzugsweise alle aktuell existenten bzw. vorgeschlagenen Modelgrenzen ins Model eingezeichnet. Alternativ oder ergänzend können diese Partitionen und die Grenzen auch in einem Graph des Models, der anhand des erfindungsgemäßen Verfahrens erstellt wurde, angezeigt werden. Die aktuell gezogene Grenze kann dabei auch innerhalb einer Partition, statt zwischen zwei Partitionsgrenzen verlaufen, wie weiter unten diskutiert wird. Wichtig ist dabei, dass ein FPGA Model i.d.R. nicht durch einen einzigen zusammenhängenden Graphen, sondern durch mehrere Inselgraphen repräsentiert wird. Das liegt daran, dass in einem FPGA oft mehrere autarke Funktionalitäten umgesetzt werden, die nicht untereinander kommunizieren, sondern eine nur über I/O-Pins verbundene feste Funktionalität bereitstellen oder jeweils nur mit ihrem Prozessoranteil kommunizieren. Daher gibt es i.d.R. nicht nur eine Grenze zwischen Prozessor und FPGA, sondern eine für jeden Inselgraphen, also für voneinander vollständig unabhängige Funktionalitäten.

Der Nutzer bekommt nun vorzugsweise die Möglichkeit, nach Anklicken einer Grenze im Model oder im Graph des Models diese Grenze interaktiv z.B. durch Verschiebung mit einem Slider oder direkter Verschiebung im Model oder Graph des Models, diese spezielle Grenze mehr Richtung Prozessor oder FPGA zu verschieben. Zusätzlich kann die Granularität der Modelldarstellung reduziert werden, indem Teile die nur als Ganzes verschoben werden können (wie atomare zyklische Gruppen) zu einzelnen Subsystemen/Knotenpunkten zusammengefasst werden.

Dabei werden bevorzugt interaktiv eine oder mehrere der folgenden Angaben aktualisiert dargestellt:
- Interfacebreite zwischen Prozessor und FPGA in Bit und Kommunikationsdauer für die Übertragung dieser Bits bei einer vorgegebenen maximalen Datenrate (z.B. 2.5 Gbit/s). Dadurch kann der Nutzer erkennen, um welchen Wert sich seine minimal erreichbare Taskperiode aufgrund der Kommunikation verändern wird. In einer Ausführungsform können auch die Veränderungen der entsprechenden Werte zu den bestehenden / vorgeschlagenen Grenzen angezeigt werden.
- Benötigte Logikressourcen im FPGA. Diese Ressourcen der einzelnen Modelblöcke/Subsysteme und der ungefähr erreichbare Takt können auf Basis einer Synthese des Gesamtmodells ermittelt werden, die vorzugswiese nach Erstellen einer unimplementierten Netzliste abgebrochen wird. Somit kann vorab ermittelt werden, ob ein entsprechend partitioniertes Modell auf dem Echtzeitrechnersystem ausgeführt werden kann.

Im Folgenden wird die Bedeutung der Partitionen für die Verschiebung der Grenzen diskutiert. Die Partitionsansicht mit eingetragenen Grenzen offenbart dem Nutzer viele Informationen auf einen Blick, so dass es auf den ersten Blick ersichtlich ist, ob eine Grenze bereits auf einer Partitionsgrenze oder innerhalb einer Partition liegt. Wenn die Grenze innerhalb einer Partition liegt, die sich für Prozessor oder FPGA eignet, so kann sie leicht in eine Richtung der beiden Partitionsgrenzen Richtung Prozessor oder FPGA verschoben werden, wodurch sich ggfs. die Interfacebreiten der Datenkommunikation ändern.

Figur 10a zeigt eine schematische Darstellung eines einfachen Modells mit einer Grenze. Links befindet sich ein fest auf dem FPGA auszuführender Block (FPGA Fixpunkt), und rechts ein fest auf dem Prozessor auszuführender Block (Prozessor Fixpunkt). Dazwischen liegen mehrere jeweils durch eine Signallinie verbundene Blöcke. Hierbei sind Blöcke, die auf dem FPGA auszuführen sind, schwarz dargestellt, auf dem Prozessor auszuführende Blöcke sind weiß dargestellt, und flexibel anzuordnende Blöcke sind grau dargestellt. Bei der dargestellten Partitionierung kann der Nutzer seinen FPGA Anteil (das zweite Teilmodell) vergrößern, indem er die Grenze nach rechts schiebt. Dann liegt bis auf den dargestellten Prozessor Fixpunkt ein reines FPGA Modell vor.

Ausgehend von der in Figur 10a dargestellten Grenze kann der Nutzer alternativ den Prozessor-Anteil des Modells vergrößern und die Grenze ggfs. sogar über mehrere Partitionen hinaus verschieben. Bei einer derart nach links verschobenen Grenze ist würde zunächst ein auf dem FPGA auszuführender Block hinter der Grenze zum Prozessormodell liegen (der rechte schwarze Kreis). Wenn der Nutzer den auf dem FPGA auszuführenden Block und die Grenze unverändert lässt, werden in einer bevorzugten Ausführungsform der Erfindung automatisch weitere Grenzen auf dem Signalpfad eingefügt. Figur 10b zeigt eine schematische Darstellung des einfachen Modells, bei dem automatisiert weitere Grenzen im Signalpfad eingefügt wurden. Diese Grenzen erfordern eine Kommunikation zwischen Prozessor und FPGA und erhöhen damit den Kommunikationsaufwand, wobei die Kommunikation ggfs. blockierend sein kann. Mit einer blockierenden Kommunikation ist hierbei insbesondere gemeint, dass eine weitere Berechnung erst erfolgen kann, nachdem die Datenübertragung zwischen Prozessor und FPGA abgeschlossen wurde.

Passt der Nutzer seine Modellierung in der FPGA-Partition bzw. dem entsprechenden dem FPGA zugeordneten Block (rechter schwarzer Kreis) an, und ermöglicht eine Zuordnung dieses Blocks zur Prozessor-Partition, so verringert sich der Kommunikationsaufwand. Figur 10c zeigt eine schematische Darstellung des einfachen Modells, bei dem die verschobene Grenze beibehalten wurde, aber die Anzahl von weiteren Grenzen durch eine geänderte Einstellung des mittleren Blocks verringert wurde. Die grafische Darstellung der Aufteilung des Modells in einer Partitionsansicht erleichtert es dem Nutzer zu erkennen, dass eine geänderte Modellierung zu einer verringerten Anzahl von Grenzen bzw. Übergängen zwischen Prozessor und FPGA führt. Wegen des verringerten Kommunikationsaufwands kann die geänderte Modellierung in einer schnelleren Ausführung des Gesamtmodells resultieren.

Alternative Ausführungsformen der Erfindung ermöglichen auch die Festlegung einer größeren Anzahl von Grenzen, insbesondere je zwei, zwischen Prozessor und FPGA Anteil. Indem passende Regeln definiert werden, können zusätzliche Anteile an der Grenze zwischen FPGA und Prozessor definiert werden, deren Ausführung flexibel festgelegt werden kann. Werden beispielsweise im Gesamtmodel oder im Model Graph des Gesamtmodels für jede Input und Output Grenze zwischen den Modelanteilen nicht nur eine Trennlinie, sondern zwei definiert, hat man jeweils eine Zone zwischen den Modelanteilen. Die Blöcke in dazwischenliegenden Zonen können dann beispielsweise auf dem Prozessor ausgeführt werden, während der Rest des Modells auf dem FPGA implementiert ist.

Durch die Erfindung wird eine automatische oder computerunterstützte Zerlegung von Modellen für die Ausführung auf heterogenen Simulatoren möglich, was die Zeit für den Entwurf einer Simulation deutlich verkürzen kann.

## Patentansprüche

1. Verfahren zur Aufteilung eines grafischen Simulationsmodells in ein erstes Teilmodell und ein zweites Teilmodell, wobei die Funktionalität des Simulationsmodells in Form von Blöcken modelliert ist, die zumindest teilweise durch Signale verbunden sind, wobei die Blöcke periodisch ausgeführt werden und jedem Block des Simulationsmodell eine Sampling-Zeit zugeordnet ist, wobei das erste Teilmodell dazu bestimmt ist, auf einer ersten Recheneinheit, insbesondere einem Prozessor, ausgeführt zu werden, und das zweite Teilmodell dazu bestimmt ist, auf einer zweiten Recheneinheit, einem programmierbaren Logikbaustein, ausgeführt zu werden, das Verfahren umfassend die aufeinanderfolgenden Schritte:
a. Identifizieren mindestens eines ersten Blocks als zum ersten Teilmodell gehörend und mindestens eines zweiten Blocks als zum zweiten Teilmodell gehörend, wobei die Zugehörigkeit anhand der Sampling-Zeit und/oder einer Ressourcen-Zuordnung bestimmt wird,
b. Suchen von zyklischen Gruppen aus Blöcken, wobei eine zyklische Gruppe zwei oder mehr Blöcke umfasst, die über mindestens ein Signal verbunden sind, wobei ein erster Block der zyklischen Gruppe ein Signal an einen zweiten Block in der Gruppe ausgibt und ein Ausgangssignal des zweiten Blocks zumindest mittelbar empfängt, wobei eine zyklische Gruppe, deren Blöcke alle dieselbe Sampling-Zeit aufweisen, als atomar angesehen wird,
c. Identifizieren nichtzyklischer Gruppen aus Blöcken,
d. Zuordnen der einzelnen Blöcke aus den Gruppen zu dem ersten Teilmodell oder dem zweiten Teilmodell, wobei alle Blöcke einer atomaren zyklischen Gruppe demselben Teilmodell zugeordnet werden,
e. Erzeugen von Code für die erste Recheneinheit, insbesondere von Programmcode, aus dem ersten Teilmodell, und
f. Erzeugen von Code für die zweite Recheneinheit, von einem Konfigurationsbitstrom, aus dem zweiten Teilmodell.

2. Verfahren nach Anspruch 1, **dadurch gekennzeichnet, dass** das Simulationsmodell mindestens einen Block in einer ersten Hierarchieebene und mindestens einen Block in einer zweiten Hierarchieebene umfasst, und dass vor den weiteren Schritten ein Zusammenführen der Blöcke des Simulationsmodells in einer gemeinsamen Hierarchieebene erfolgt.

3. Verfahren nach Anspruch 2, **dadurch gekennzeichnet, dass** das Simulationsmodell Eingangsports, Ausgangsports und/oder Busse enthält, und dass der Schritt des Zusammenführens der Blöcke des Simulationsmodells in einer gemeinsamen Hierarchieebene ein Entfernen zumindest von einigen der Eingangsports, Ausgangsports und/oder Busse sowie ein Einfügen entsprechender Signale umfasst.

4. Verfahren nach einem der vorhergehenden Ansprüche, **dadurch gekennzeichnet, dass** ein Block als zum zweiten Teilmodell gehörend identifiziert wird, wenn eine oder mehrere der folgenden Bedingungen erfüllt ist/sind:
I. dem Block ist eine Sampling-Zeit zugeordnet, die unterhalb eines vorgegebenen Samplingschwellenwerts liegt;
II. dem Block ist eine Latenz zugeordnet, die unterhalb eines vorgegebenen Latenzschwellenwerts liegt;
III. dem Block ist eine Ressource des FPGA zugeordnet, wie insbesondere ein I/O-Pin des FPGA.

5. Verfahren nach einem der vorhergehenden Ansprüche, **dadurch gekennzeichnet, dass** ein Block als zum ersten Teilmodell gehörend identifiziert wird, wenn eine oder mehrere der folgenden Bedingungen erfüllt ist/sind:
I. der Block beschreibt einen Funktionsaufruf, insbesondere eine Funktion des Betriebssystems und/oder einen Zugriff auf eine Netzwerkschnittstelle;
II. dem Block ist eine Ressource des Prozessors zugeordnet, wie insbesondere ein Register des Prozessors.

6. Verfahren nach einem der vorhergehenden Ansprüche, **dadurch gekennzeichnet, dass** der Schritt des Suchens von zyklischen Gruppen eine rekursive Unterteilung umfasst, wobei für eine gefundene zyklische Gruppe überprüft wird, ob alle Blöcke die gleiche Sampling-Zeit haben, wobei in dem Fall die zyklische Gruppe als atomar angesehen und beibehalten wird, und andernfalls die zyklische Gruppe zwischen Blöcken mit unterschiedlicher Sampling-Zeit in neue zyklische oder nichtzyklische Teilgruppen unterteilt wird, bis keine unterteilbaren zyklischen Gruppen mehr vorliegen.

7. Verfahren nach einem der vorhergehenden Ansprüche, **dadurch gekennzeichnet, dass** der Schritt des Zuordnens der einzelnen Blöcke aus den Gruppen zu dem ersten Teilmodell oder dem zweiten Teilmodell anhand einer vorgegebenen Regel erfolgt.

8. Verfahren nach Anspruch 7, **dadurch gekennzeichnet, dass** gemäß der Regel alle Blöcke, die nicht auf dem programmierbaren Logikbaustein ausgeführt werden müssen, dem ersten Teilmodell zugeordnet werden.

9. Verfahren nach Anspruch 8, **dadurch gekennzeichnet, dass** ein Block auch dann auf dem programmierbaren Logikbaustein ausgeführt werden muss, wenn dieser über ein Signal mit einem als zum zweiten Teilmodell gehörend identifizierten Block verbunden ist, und das Signal eine höhere Bitbreite als ein Breitenschwellenwert und/oder eine höhere Änderungsfrequenz als ein Änderungsschwellenwert und/oder das Signal eine kürzere Latenz als ein Signallatenzschwellenwert aufweist.

10. Verfahren nach einem der vorhergehenden Ansprüche, **dadurch gekennzeichnet, dass** nach dem Schritt des Zuordnens der einzelnen Blöcke aus den Gruppen zu dem ersten Teilmodell oder dem zweiten Teilmodell eine grafische Darstellung des aufgeteilten Modells über eine Benutzeroberfläche angezeigt wird, und dass Änderungen an der Aufteilung über die Benutzeroberfläche empfangen werden.

11. Verfahren nach Anspruch 10, **dadurch gekennzeichnet, dass** anhand einer Zusatzregel, insbesondere anhand des Fehlens einer Ressourcen-Zuordnung, Blöcke identifiziert werden, die sowohl dem ersten Teilmodell als auch dem zweiten Teilmodell zugeordnet werden können, wobei diese Blöcke hervorgehoben auf der Benutzeroberfläche dargestellt werden, und die Zuordnung dieser Blöcke anhand einer Benutzereingabe erfolgt.

12. Verfahren nach einem der vorhergehenden Ansprüche, **dadurch gekennzeichnet, dass** nach dem Schritt des Zuordnens der einzelnen Blöcke aus den Gruppen zu dem ersten Teilmodell oder dem zweiten Teilmodell ein zusätzlicher Schritt des Einfügens von Kommunikationsblöcken erfolgt, wobei für zwei durch ein Signal verbundene Blöcke überprüft wird, ob diese unterschiedlichen Teilmodellen zugeordnet sind, und in dem Fall ein paar von Kommunikationsblöcken eingefügt wird, die einen Datenaustausch zwischen Prozessor und programmierbarem Logikbaustein implementieren.

13. Verfahren nach einem der vorhergehenden Ansprüche, **gekennzeichnet durch** die weiteren Schritte
g. Übertragen des Programmcodes und des Konfigurationsbitstroms auf ein Echtzeitrechnersystem umfassend einen Prozessor und eine programmierbaren Logikbaustein, und
h. Durchführen einer Simulation, wobei der Prozessor den Programmcode ausführt und die Funktionalität des programmierbaren Logikbausteins durch den Konfigurationsbitstrom bestimmt wird.

14. Rechnersystem, umfassend einen Bedienrechner mit einer Bedienoberfläche und einem Echtzeitrechner mit einem Prozessor, einem programmierbaren Logikbaustein und I/O-Schaltungen, **dadurch gekennzeichnet, dass** auf einem nichtflüchtigen Speicher des Rechnersystems Instruktionen zur Durchführung eines Verfahrens nach einem der vorhergehenden Ansprüche hinterlegt sind.

15. Nichtflüchtiger Datenträger mit einem computerlesbaren Speichermedium, auf dem Befehle eingebettet sind, die, wenn sie von einem Prozessor ausgeführt werden, bewirken, dass der Prozessor dazu eingerichtet ist, ein Verfahren gemäß einem der Ansprüche 1-13 auszuführen.

## Claims

1. A method for dividing a graphical simulation model into a first submodel and a second submodel, the functionality of the simulation model being modeled in the form of blocks at least partially connected by signals, the blocks being executed periodically and a sampling time being associated with each block of the simulation model, the first submodel being intended to be executed on a first computing unit, in particular a processor, and the second submodel being intended to be executed on a second computing unit, a programmable logic device, the method comprising the sequential steps:
a. identifying at least one first block as associated with the first submodel and at least one second block as associated with the second submodel, the association being determined on the basis of the sampling time and/or a resource allocation,
b. searching for cyclic groups of blocks, a cyclic group comprising two or more blocks connected by means of at least one signal, a first block of the cyclic group outputting a signal to a second block in the group and receiving an output signal of the second block at least indirectly, a cyclic group comprising blocks all having the same sampling time being considered atomic,
c. identifying non-cyclic groups of blocks,
d. associating the individual blocks from the groups to the first submodel or the second submodel, all blocks of an atomic cyclic group being associated with the same submodel,
e. generating code for the first computing unit, in particular program code, from the first submodel, and
f. generating code for the second computing unit, a configuration bitstream, from the second submodel.

2. The method according to claim 1, **characterized in that** the simulation model comprises at least one block in a first hierarchy level and at least one block in a second hierarchy level, and **in that** merging of the blocks of the simulation model into a common hierarchy level takes place prior to the further steps.

3. The method according to claim 2, **characterized in that** the simulation model comprises input ports, output ports, and/or buses, and **in that** the step of merging the blocks of the simulation model in a common hierarchy level comprises removing at least some of the input ports, output ports, and/or buses and inserting corresponding signals.

4. The method according to any one of the preceding claims, **characterized in that** a block is identified as being associated with the second submodel if one or more of the following conditions is/are fulfilled:
I. the block is associated with a sampling time below a specified sampling threshold;
II. the block is associated with a latency below a specified latency threshold;
III. a resource of the FPGA is associated with the block, such as in particular an I/O pin of the FPGA.

5. The method according to any one of the preceding claims, **characterized in that** a block is identified as being associated with the first submodel if one or more of the following conditions is/are fulfilled:
I. the block describes a function call, in particular a function of the operating system and/or access to a network interface;
II. the block is associated with a resource of the processor, such as in particular a register of the processor.

6. The method according to any one of the preceding claims, **characterized in that** the step of searching cyclic groups comprises recursively subdividing, wherein a found cyclic group is checked as to whether all blocks have the same sampling time, wherein if so, the cyclic group is regarded as atomic and retained, and otherwise the cyclic group is divided by blocks having different sampling times into new cyclic or non-cyclic subgroups until there are no more divisible cyclic groups.

7. The method according to any one of the preceding claims, **characterized in that** the step of associating the individual blocks from the groups with the first submodel or the second submodel is carried out on the basis of a specified rule.

8. The method according to claim 7, **characterized in that**, according to the rule, all blocks which do not have to be executed on the programmable logic device are associated with the first submodel.

9. The method according to claim 8, **characterized in that** a block must also be executed on the programmable logic device if said block is connected via a signal to a block identified as associated with the second submodel, and the signal has a higher bit width than a width threshold and/or a higher change frequency than a change threshold and/or the signal has a shorter latency than a signal latency threshold.

10. The method according to any one of the preceding claims, **characterized in that**, after the step of associating the individual blocks from the groups with the first submodel or the second submodel, a graphical representation of the divided model is displayed via a user interface, and **in that** changes to the division are received via the user interface.

11. The method according to claim 10, **characterized in that** blocks able to be associated with both the first submodel and to the second submodel are identified on the basis of an additional rule, in particular on the basis of the absence of a resource assignment, wherein said blocks are highlighted on the user interface and said blocks are associated based on user input.

12. The method according to any one of the preceding claims, **characterized in that**, after the step of associating the individual blocks from the groups with the first submodel or the second submodel, an additional step of inserting communication blocks takes place, wherein for two blocks connected by a signal it is checked whether said blocks are associated with different submodels and, if so, a pair of communication blocks is inserted for implementing a data exchange between the processor and programmable logic device.

13. The method according to any one of the preceding claims, **characterized by** the additional steps of
g. transmitting the program code and the configuration bitstream to a real-time computer system comprising a processor and a programmable logic device, and
h. performing a simulation wherein the processor executes the program code and the functionality of the programmable logic device is determined by the configuration bitstream.

14. A computer system comprising an operating computer having a user interface and a real-time computer having a processor, a programmable logic device, and I/O circuits, **characterized in that** instructions for performing a method according to any one of the preceding claims are stored in a non-volatile memory of the computer system.

15. A non-volatile data carrier having a computer-readable storage medium on which commands are embedded for bringing about, when implemented by a processor, the state that the processor is configured to implement a method according to any one of the claims 1 through 13.

## Revendications

1. Procédé de division d'un modèle graphique de simulation en un premier modèle partiel et un deuxième modèle partiel, la fonctionnalité du modèle de simulation étant modélisée sous forme de blocs qui sont au moins partiellement reliés par des signaux, les blocs étant exécutés périodiquement et un temps d'échantillonnage étant associé à chaque bloc du modèle de simulation, le premier modèle partiel étant destiné à être exécuté sur une première unité de calcul, en particulier un processeur, et le deuxième modèle partiel étant destiné à être exécuté sur une deuxième unité de calcul, un module logique programmable, la procédure comprend les étapes successives:
a. identifier au moins un premier bloc comme appartenant au premier modèle partiel et au moins un deuxième bloc comme appartenant au deuxième modèle partiel, l'appartenance étant déterminée à l'aide du temps d'échantillonnage et/ou d'une affectation de ressources,
b. rechercher des groupes cycliques de blocs, un groupe cyclique comprenant deux ou plusieurs blocs qui sont reliés par au moins un signal, un premier bloc du groupe cyclique délivrant un signal à un deuxième bloc du groupe et recevant au moins indirectement un signal de sortie du deuxième bloc, un groupe cyclique dont les blocs présentent tous le même temps d'échantillonnage étant considéré comme atomique,
c. identifier les groupes non cycliques dans des blocs,
d. affecter les blocs individuels des groupes au premier modèle partiel ou au deuxième modèle partiel, tous les blocs d'un groupe cyclique atomique étant affectés au même modèle partiel,
e. générer un code pour la première unité de calcul, en particulier un code de programme, à partir du premier modèle partiel, et
f. générer un code pour la deuxième unité de calcul, depuis un train de bits de configuration, à partir du deuxième model partiel.

2. Procédé selon la revendication 1, **caractérisé en ce que** le modèle de simulation comprend au moins un bloc dans un premier niveau de hiérarchie et au moins un bloc dans un deuxième niveau de hiérarchie, et **en ce que**, avant les étapes suivantes, un regroupement des blocs du modèle de simulation dans un niveau de hiérarchie commun est effectué.

3. Procédé selon la revendication 2, **caractérisé en ce que** le modèle de simulation comprend des ports d'entrée, des ports de sortie et/ou des bus, et **en ce que** l'étape de regroupement des blocs du modèle de simulation dans un niveau de hiérarchie commun comprend une suppression d'au moins certains des ports d'entrée, des ports de sortie et/ou des bus, ainsi qu'une insertion de signaux correspondants.

4. Procédé selon l'une des revendications précédentes, **caractérisé en ce qu'**un bloc est identifié comme appartenant au deuxième modèle partiel si une ou plusieurs des conditions suivantes est/sont remplie(s):
I. un temps d'échantillonnage inférieur à une valeur seuil d'échantillonnage prédéfinie est associé au bloc ;
II. une latence inférieure à une valeur seuil de latence prédéfinie est associée au bloc ;
III. une ressource du FPGA est associée au bloc, comme en particulier une broche d'E/S du FPGA.

5. Procédé selon l'une des revendications précédentes, **caractérisé en ce qu'**un bloc est identifié comme appartenant au premier modèle partiel si une ou plusieurs des conditions suivantes est/sont remplie(s):
I. le bloc décrit un appel de fonction, en particulier une fonction du système d'exploitation et/ou un accès à une interface réseau ;
II. une ressource du processeur est associée au bloc, comme en particulier un registre du processeur.

6. Procédé selon l'une des revendications précédentes, **caractérisé en ce que** l'étape de recherche de groupes cycliques comprend une subdivision récursive, sachant que, pour un groupe cyclique trouvé, il est vérifié si tous les blocs ont le même temps d'échantillonnage, dans ce cas, le groupe cyclique étant considéré comme atomique et conservé, et, dans le cas contraire, le groupe cyclique étant subdivisé en nouveaux groupes partiels cycliques ou non cycliques entre des blocs ayant des temps d'échantillonnage différents, jusqu'à ce qu'il n'y ait plus de groupes cycliques subdivisibles.

7. Procédé selon l'une des revendications précédentes, **caractérisé en ce que** l'étape consistant à affecter les blocs individuels des groupes au premier modèle partiel ou au deuxième modèle partiel est effectuée à l'aide d'une règle prédéterminée.

8. Procédé selon la revendication 7, **caractérisé en ce que**, conformément à la règle, tous les blocs qui ne doivent pas être exécutés sur le module logique programmable sont affectés au premier modèle partiel.

9. Procédé selon la revendication 8, **caractérisé en ce qu'**un bloc doit être exécuté sur le module logique programmable même si celui-ci est relié par un signal à un bloc identifié comme appartenant au deuxième modèle partiel, et le signal présente une largeur de bits supérieure à une valeur seuil de largeur et/ou une fréquence de variation supérieure à une valeur seuil de variation et/ou le signal présente une latence plus courte qu'une valeur seuil de latence de signal.

10. Procédé selon l'une des revendications précédentes, **caractérisé en ce que**, après l'étape consistant à affecter les blocs individuels des groupes au premier modèle partiel ou au deuxième modèle partiel, une représentation graphique du modèle divisé est affichée via une interface utilisateur, et **en ce que** des modifications de la division sont reçues via l'interface utilisateur.

11. Procédé selon la revendication 10, **caractérisé en ce qu'**à l'aide d'une règle supplémentaire, en particulier à l'aide de l'absence d'une affectation de ressources, des blocs sont identifiés, qui peuvent être affectés aussi bien au premier modèle partiel qu'au deuxième modèle partiel, ces blocs étant représentés en exergue et l'affectation de ces blocs se faisant sur la base d'une saisie de l'utilisateur.

12. Procédé selon l'une des revendications précédentes, **caractérisé en ce que**, après l'étape d'affectation des blocs individuels des groupes au premier modèle partiel ou au deuxième modèle partiel, il est effectué une étape supplémentaire d'insertion de blocs de communication, une vérification étant effectuée pour deux blocs reliés par un signal afin de déterminer si ceux-ci sont affectés à des modèles partiels différents, et une paire de blocs de communication étant insérée dans ce cas, qui mettent en œuvre un échange de données entre le processeur et le module logique programmable.

13. Procédé selon l'une des revendications précédentes, **caractérisé par** les étapes supplémentaires
g. transmettre le code de programme et le train de bits de configuration à un système de calculateur en temps réel comprenant un processeur et un module logique programmable, et
h. exécuter une simulation, le processeur exécutant le code de programme et la fonctionnalité du bloc logique programmable étant déterminée par le train de bits de configuration.

14. Système de calculateurs, comprenant un calculateur de commande avec une interface utilisateur et un calculateur en temps réel avec un processeur, un module logique programmable et des circuits E/S, **caractérisé en ce que** des instructions destinées à la mise en œuvre d'un procédé selon l'une des revendications précédentes sont stockées dans une mémoire non volatile du système de calculateurs.

15. Support de données non volatile avec un support de stockage lisible par ordinateur, sur lequel sont incorporées des instructions qui, lorsqu'elles sont exécutées par un processeur, font à ce que le processeur soit configuré pour mettre en œuvre un procédé selon l'une des revendications 1 à 13.
